Europäisches Patentamt

European Patent Office

Office européen des brevets

(19)

(11) **EP 0 760 024 B1**

(12) **EUROPÄISCHE PATENTSCHRIFT**

(45) Veröffentlichungstag und Bekanntmachung des Hinweises auf die Patenterteilung:
**07.07.1999 Patentblatt 1999/27**

(51) Int Cl.$^6$: **C30B 11/00**, C30B 35/00, C30B 29/42

(21) Anmeldenummer: **95919958.9**

(86) Internationale Anmeldenummer:
**PCT/DE95/00667**

(22) Anmeldetag: **12.05.1995**

(87) Internationale Veröffentlichungsnummer:
**WO 95/31591 (23.11.1995 Gazette 1995/50)**

(54) **VERFAHREN UND VORRICHTUNG ZUR GEWINNUNG RISSFREIER KRISTALLE**

PROCESS AND DEVICE FOR OBTAINING UNFISSURED CRYSTALS

PROCEDE ET DISPOSITIF PERMETTANT D'OBTENIR DES CRISTAUX SANS FISSURE

(84) Benannte Vertragsstaaten:
**CH DE FR GB LI NL**

(30) Priorität: **16.05.1994 DE 4417105**

(43) Veröffentlichungstag der Anmeldung:
**05.03.1997 Patentblatt 1997/10**

(73) Patentinhaber: **FORSCHUNGSZENTRUM JÜLICH GMBH**
**52425 Jülich (DE)**

(72) Erfinder:
• **ALTHAUS, Martin**
  **D-52428 Jülich (DE)**
• **KÜSSEL, Eckhard**
  **D-52352 Düren (DE)**
• **SONNENBERG, Klaus**
  **D-52382 Niederzier (DE)**

(56) Entgegenhaltungen:
**EP-A- 0 104 741    US-A- 3 041 690**

**Beschreibung**

Die Erfindung bezieht sich auf ein Verfahren zur Gewinnung rißfreier Kristalle, nachdem der Kristall durch eine gerichtete Erstarrung aus einer in einem Quarztiegel befindlichen Schmelze gebildet worden ist und sich Kristall und Tiegel noch auf einer Temperatur oberhalb etwa 300°C befinden. Sie bezieht sich ferner auf eine Vorrichtung zur Durchführung des Verfahrens.

Das Halbleitermaterial Galliumarsenid (GaAs) gehört zu der Gruppe der III/V-Halbleiter und weist gegenüber dem klassischen Halbleiter Silicium einige physikalisch interessante Eigenschaften auf. Hier sind vor allem der semmiisolierende Charakter des GaAs, der direkte Bandübergang sowie die hohe Mobilität zu erwähnen.

Die wirtschaftliche Bedeutung dieses Materials liegt in seinem hohen Anwendungspotential in der Optoelektronik und Hochfrequenztechnik, die den wachsenden Anforderungen einer Informationsgesellschaft Rechnung tragen.

Konkrete Anwendungen in Form von LEDs, Lasern, Mikrowellendioden sowie Solarzellen werden durch hochdotierte und somit leitende Einkristallwafer abgedeckt.

Eine wesentliche Voraussetzung für eine industrielle Anwendung der III/V-Halbleitertechnologie ist die Sicherung und Verbesserung der GaAs-Substratherstellung, so daß hinsichtlich dieser Zielsetzung der hohe Forschungsaufwand auf dem Gebiet der Kirstallzüchtung gerechtfertigt ist.

Das gegenwärtig in der Industrie stark verbreitete Verfahren ist das Czochralski-Verfahren. Seine Anwendung liegt zu einem sehr großen Teil in dem erfolgreichen Einsatz dieses Verfahrens in der Siliciumkristallzucht begründet. Bei der GaAs-Züchtung zeigen jedoch andere Verfahren bessere Ergebnisse auf. Kristalle, die mit dem Vertikalen Bridgman (VB) Verfahren gezüchtet wurden, weisen eine um den Faktor 10 geringere Versetzungsdichte auf, wobei aufgrund der möglichen Automatisierbarkeit dieses Verfahren eine Möglichkeit für eine kostengünstige Produktion bietet.

Die notwendige Bedingung, die Züchtung des Einkristalls beim VB-Verfahren in einem Tiegel durchzuführen, geht mit dem Problem der Kontaktierung der Schmelze mit dem Tiegelmaterial einher. Diese Kontaktierung wird durch die totale Flüssigkeitsumkapselung umgangen, so daß der Kristall quasitiegelfrei wächst. Als Tiegelmaterial wird Quarzglas verwendet. Bei der benetzenden Flüssigkeit handelt es sich um Boroxid.

Die in einem Quarztiegel gezüchteten Kristalle - außer GaAs auch andere wie beispielsweise Indiumphosphid - weisen eine bedeutend geringere Tendenz zum Polywachstum und zur Zwillungsbildung im Vergleich zum bisher verwendeten pyrolytischen Bornitridtiegel auf. D.h., daß die Ausbeute an einkristallinem GaAs mit diesem Tiegelmaterial stark erhöht werden kann und somit zur Erhöhung der Wirtschaftlichkeit des VB-Verfahrens beiträgt.

Der Quarztiegel hat jedoch den Nachteil, daß die Kristalle während des Abkühlvorgangs Risse bei der Verfestigung des Boroxids bilden; dieser Vorgang beruht auf den unterschiedlichen thermischen Ausdehnungskoeffizienten des Quarzglases und des GaAs. Die bei Temperaturen unterhalb der 300°C-Grenze verstärkt einsetzende Rißbildung im Kristall deckt sich mit der in der Literatur bekannten Erweichungszone des Boroxids, die sich von ca. 325°C bis hinauf zur Schmelztemperatur (450°C) erstreckt.

Es ist daher Aufgabe der Erfindung, ein Verfahren gemäß anspruch 1 zu schaffen, das eine rißfreie Gewinnung des bereits fertig gezogenen Kristalls erlaubt. Aufgabe der Erfindung ist ferner eine Vorrichtung gemäß anspruch 5 zur Durchführung des Verfahrens.

Diese Aufgabe wird erfindungsgemäß dadurch gelöst, daß der Quarztiegel zu seiner Zerstörung in eine Schmelze einer silikatbildenden Hydroxidverbindung getaucht wird, die sich auf einer Temperatur von etwa 450 - 600°C befindet.

Wie sich gezeigt hat, ist durch die Zerstörung des Tiegels die Möglichkeit gegeben, einen rißfreien Kristall zu erhalten. Diese Zerstörung muß oberhalb des Erstarrungspunktes des Boroxids liegen, also im angegebenen Temperaturbereich.

Als Hydroxidverbindungen kommen beispielsweise NaOH oder KOH infrage, wobei beide Substanzen im gleichen Preisniveau liegen.

Beide Stoffe weisen einen Schmelzpunkt im 300 - 400°C-Bereich auf (NaOH = 318,4°C. KOH = 360,4°C) und eine Verdampfungstemperatur oberhalb der Schmelztemperatur von GaAs (NaOH = 1390°C, KOH = 1322°C). Sie eignen sich somit bestens für eine Zerstörung des Quarzglases bei ca. 500°C. Beide Substanzen zeigten, daß die Zerstörung des Quarzglases wirkungsvoller ist, wenn das Glas von der Schmelze bedeckt wurde. Eine Zerstörung des Glases durch die Gasphase über der Schmelze wurde ebenfalls beobachtet, jedoch zeigten die Versuche, daß diese Reaktion konzentrationsabhängig ist. Vom Standpunkt einer gleichmäßigen Zerstörung des Tiegels ist somit die direkte Zerstörung des Tiegels in einer Salzschmelze vorzuziehen.

Beide Hydroxide zerstören einen Tiegel mit einer Wandstärke von 2 mm in kurzen Zeiträumen von ca. 1 h, wobei das KOH eine um den Faktor 2 größere Reaktionsgeschwindigkeit zeigte. Bei den in den Versuchen verwendeten Stoffmengen wurden Abtragungsgeschwindigkeiten von ca. 3 mm/h bei einer Temperatur von ca. 500°C beobachtet. Die Reaktion der Silikatbildung kann wie folgt geschrieben werden:

$$2\,KOH + SiO_2 \rightarrow K_2SiO_3 + H_2O$$

Das Silikat war später als Bodensatz im Tiegel zu erkennen, in dem sich die KOH-Schmelze befand.

Das Oxid Boroxid reagiert mit einer Hydroxidschmelze zu giftigen Boraten, die eine Hydratisierung erfahren können. Da das Boroxid bei einer Temperatur von ca. 500°C auch hydratisiert in Form der Metaborsäure vorliegen kann, sind folgende Reaktionen mit der KOH-Schmelze möglich

$$3\,B_2O_3 + 6\,KOH \rightarrow 2\,K_3B_3O_6 + 3\,H_2O$$

$$3\,HBO_2 + 3\,KOH \rightarrow K_3B_3O_6 + 3\,H_2O$$

Bei einem Lösungsversuch wurden Bereiche oberhalb der Schmelze beobachtet, die sich selbst entzündeten. Dies könnte entweder auf sich in Luft selbstenzündende Borane oder aber auf entweichenden Wasserstoff hinweisen, obwohl beide Reaktionen bei den verwendeten Chemikalien eigentlich nicht zu erwarten sind.

Durch Eintauchen eines Thermoelements in die Boroxid-Haube, die den GaAs-Kristall abdeckt, wurde festgestellt, daß obige Reaktion stark exotherm ist. Temperaturanstiege von ca. 200°C pro Minute wurden vom Thermoelement registriert, wobei nicht geklärt werden konnte, ob die Boratbildung oder eine mögliche Hydratisierung stark exotherm verläuft.

Um zu einem rißfreien GaAs-Kristall zu gelangen, war außerdem sicherzustellen, daß eine etwaige Reaktion des Boroxids in der Hydroxidschmelze nicht zu einer Beeinträchtigung des Kristalls führt: Lösungsvorgänge mit größeren Mengen Boroxid zeigten sowohl einen stärkeren exothermen Charakter als auch eine höhere Tendenz zu einer Gasentzündung oberhalb der Schmelze, so daß die starke Wärmebildung primär von der Boratbildung herrührt.

Um bei den zu lösenden Kristallen einen thermischen Schock als Folge zu starker Temperaturanstiege zu vermeiden, ist es zweckmäßig, daß der Quarztiegel periodisch in die Schmelze eingetaucht und herausgenommen wird. Die Eintauchphase sollte dabei etwa 5 bis 10 s betragen.

Die Wirkung der Salzschmelze auf das GaAs selbst ist beispielsweise im FAlle des KOHs durch zwei Fragestellungen geprägt:

Wie groß ist die Abtragungsrate des GaAs durch die Schmelze und wie groß ist die Diffusion der Kaliumionen in den Kristall.

Aus der Untersuchung der Versetzungsdichte mit KOH ist bekannt, daß KOH GaAs nur langsam angreift, so daß von dieser Seite keine unlösbaren Handhabungsprobleme auftreten. GaAs reagiert wie folgt mit einer KOH-Schmelze:

$$GaAs + 3\,KOH \rightarrow Ga(OH)_3 + K_3As$$

Die später durchgeführten Versuche mit in Quarzglas gezüchteten Kristallen bestätigten diese Erwartungen.

Die Diffusion des Kaliums in den Kristall wirft ebenfalls keine unlösbaren Probleme auf. Unter der Annahme eines Diffusionsprozesses mit einer gaußförmigen Dichteverteilung liefert eine Abschätzung der zu erwartenden Standardabweichung $\sigma = \sqrt{(2Dt)}$ mit Hilfe der Diffusionskonstanten des isoelektronischen Lithiums von $10^{-6}$ cm/s$^2$ Werte in der Größenordnung von 0,85 mm. Dabei wurde eine Expositonszeit von 1 h angenommen, die der ungefähren Verweilzeit des Tiegels in der KOH-Schmelze entspricht. Es ist jedoch anzumerken, daß das GaAs erst der Schmelze ausgesetzt wird, wenn das Quarzglas zerstört und die Boroxidschicht durchdrungen ist, und daß kein elementares Kalium vorliegt.

Abschließend ist somit folgendes festzuhalten:

- Insbesondere die genannten Hydroxidverbindungen sind preisgünstig und ermöglichen eine schnelle Zerstörung des Tiegelmaterials, wobei sich das KOH gegenüber dem NaOH durch eine größere Abtragungsrate auszeichnet.

- Eine unkontrollierbare Zerstörung des GaAS-Kristalls durch die KOH-Schmelze wurde nicht beobachtet.

- Das Kalium verändert die elektrischen Eigenschaften von leitendem Bulkmaterial nicht.

Zur Durchführung des erfindungsgemäßen Verfahrens ist eine Vorrichtung geeignet, die im wesentlichen gekennzeichnet ist durch einen beheizbaren Behälter, der für die Schmelze aus einer Hydroxidverbindung vorgesehen ist, sowie eine Hubeinrichtung zum Eintauchen und Herausnehmen des Quarztiegels aus der Schmelze.

Zweckmäßigerweise ist eine Absaugeinrichtung zum Absaugen von oberhalb des Quarztiegels befindlichen Gasen vorgesehen.

Zur Durchführung des periodischen Eintauchvorganges ist ferner eine Steuerungseinrichtung für die Hubeinrichtung vorgesehen, die den Quarztiegel periodisch in die Schmelze eintaucht und herausnimmt.

In der Zeichnung ist die Vorrichtung schematisch dargestellt.

Es zeigen:

Figur 1    die Vorrichtung;

Figur 2    Quarztiegel mit Kristall und Boroxid im Schnitt.

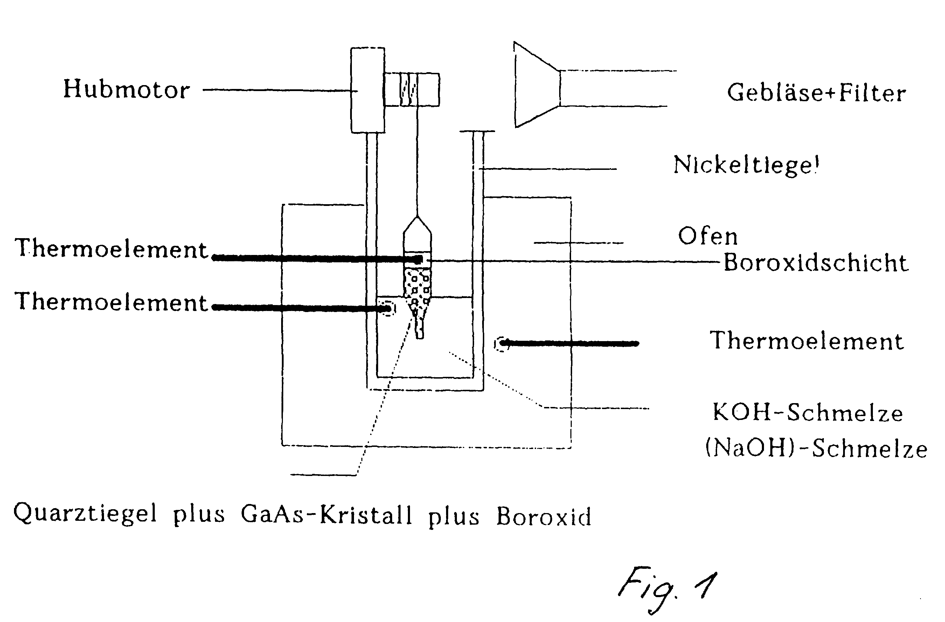

Wie aus Figur 1 hervorgeht, befindet sich die Schmelze in einem offenen Gefäß, in welchem der Quarztiegel mit dem Kristall mittels eines Hubmotors in die Schmelze eingetaucht wurde. Dieses Gefäß bestand aus Nickel, welches resistent gegen die KOH-Schmelze ist. Bei Zerstörung des Tiegels in geschlossenen Gefäßen mit entsprechenden Schutzvorkehrungen ließe sich auch ein Kohlenstoffeinsatz verwenden. Für die Temperaturregelung wurden drei Thermoelemente verwendet.

Das erste Thermoelement mißt die Temperatur im Heizofen selber, das zweite die Temperatur in der Schmelze und das dritte die Temperatur in der Boroxid-Schicht, welche stark exotherm mit der KOH-Schmelze reagiert. Temperaturschocks im Kristall infolge der exothermen Reaktion wurden dadurch vermieden, daß der Tiegel aus der Schmelze rechtzeitig herausgezogen und somit die Reaktion mit der KOH-Schmelze gestoppt wurde. Dieser periodische Eintauchvorgang kann natürlich automatisiert werden. Mögliche gasförmige Schadstoffe wurden mit Hilfe eines Gebläses plus Filter abgesaugt.

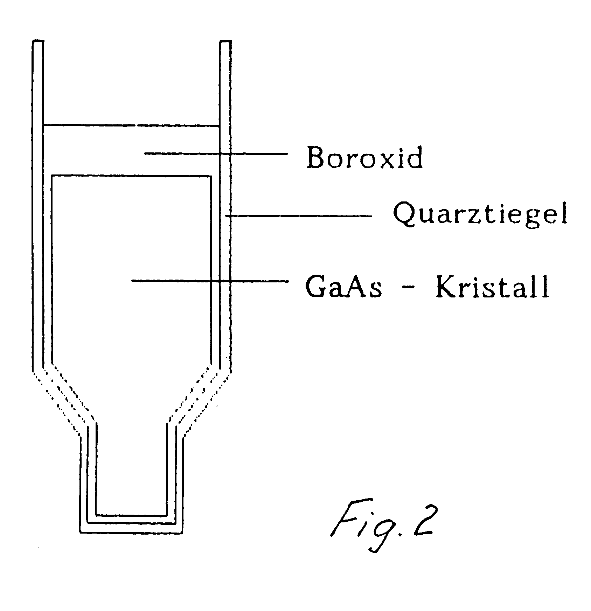

Aus Figur 2 ist ersichtlich, daß der im Quarztiegel befindliche Kristall vom Boroxid völlig umgeben ist.

## Patentansprüche

1. Verfahren zur Gewinnung rißfreier Kristalle, nachdem der Kristall durch eine gerichtete Erstarrung aus einer in einem Quarztiegel befindlichen Schmelze gebildet worden ist und sich von einer Benetzungsflüssigkeit, insbesondere Boroxid, umgebener Kristall und Tiegel noch auf einer Temperatur oberhalb etwa 300°C befinden, **dadurch gekennzeichnet**, daß der Quarztiegel zu seiner Zerstörung in eine Schmelze einer silikatbildenden Hydroxidverbindung getaucht wird, die sich auf einer Temperatur von etwa 450 - 600°C befindet.

2. Verfahren nach Anspruch 1,
   **dadurch gekennzeichnet**,
   daß die Hydroxidverbindung KOH ist.

3. Verfahren nach Anspruch 1 oder 2,
   **dadurch gekennzeichnet**,
   daß der Quarztiegel periodisch in die Schmelze eingetaucht und herausgenommen wird.

4. Verfahren nach Anspruch 3,
   **dadurch gekennzeichnet**,
   daß die Eintauchphase etwa 5 bis 10 s beträgt.

5. Vorrichtung zur Durchführung des Verfahrens gemäß einem der Ansprüche 1 bis 4,
   **gekennzeichnet durch**
   einen beheizbaren Behälter, der für die Schmelze aus einer Hydroxidverbindung vorgesehen ist, sowie eine Hubeinrichtung zum Eintauchen und Herausnehmen des Quarztiegels aus der Schmelze.

6. Vorrichtung nach Anspruch 5,
   **dadurch gekennzeichnet**,
   daß eine Absaugeinrichtung zum Absaugen der oberhalb des Quarztiegels befindlichen Gase vorgesehen ist.

7. Vorrichtung nach einem der Ansprüche 5 oder 6,
   **dadurch gekennzeichnet**,
   daß eine Steuervorrichtung für die Hubeinrichtung vorgesehen ist, die den Quarztiegel periodisch in die Schmelze eintaucht und herausnimmt.

## Claims

1. Method for obtaining crack-free crystals after the crystal has been formed by a process of directional solidification from a melt in a quartz crucible and the crystal and crucible, surrounded by a wetting fluid consisting of boron oxide, are still at a temperature above approximately 300 °C, characterised in that the quartz crucible is immersed until destruction thereof into a melt of a silicate-forming hydroxide compound which is at a temperature of approximately 450 - 600 °C.

2. Method according to claim 1, characterised in that the hydroxide compound is potassium hydroxide.

3. Method according to claim 1 or 2, characterised in that the quartz crucible is periodically immersed into and removed from the melt.

4. Method according to claim 3, characterised in that the immersion phase lasts for approximately 5 to 10 seconds.

5. Apparatus for carrying out the method as claimed in any one of claims 1 to 5, characterised by a heatable tank which is provided for the melt of a hydroxide compound, and a lifting device for immersing the quartz crucible into the melt and removing it therefrom.

6. Apparatus according to claim 5, characterised in that a suction device is provided to evacuate the gases found above the quartz crucible.

7. Apparatus according to either of claims 5 and 6, characterised in that a control device for the lifting device is provided, which periodically immerses the quartz crucible into the melt and removes it therefrom.

## Revendications

1. Procédé pour obtenir des cristaux sans fractures, selon lequel le cristal est formé au moyen d'une solidification dirigée à partir d'une masse fondue située dans un creuset en quartz, le cristal, qui est entouré par un liquide de mouillage formé d'oxyde de bore, et le creuset étant encore situés à une température supérieure à environ 300°C, caractérisé en ce qu'on immerge le creuset en quartz, pour sa destruction, dans une masse fondue formée d'un composé d'hydroxyde formant un silicate et, qui est situé à une température d'environ 450-600°C.

2. Procédé selon la revendication 1, caractérisé en ce que le composé d'hydroxyde est du KOH.

3. Procédé selon la revendication 1 ou 2, caractérisé en ce que le creuset en quartz est périodiquement immergé dans la masse fondue et en est ressorti.

4. Procédé selon la revendication 3, caractérisé en ce que la phase d'immersion dure environ 5 à 10 s.

5. Dispositif pour la mise en oeuvre du procédé selon l'une des revendications 1 à 4, caractérisé par un récipient pouvant être chauffé, qui est prévu pour la masse fondue formée d'un composé d'hydroxyde, ainsi que par un dispositif de levage pour l'immersion et le retrait du creuset en quartz de la masse fondue.

6. Dispositif selon la revendication 5, caractérisé en ce qu'il est prévu un dispositif d'aspiration servant à aspirer des gaz situés au-dessus du creuset en quartz.

7. Dispositif selon l'une des revendications 5 ou 6, caractérisé en ce qu'il est prévu un dispositif de commande pour le dispositif de levage, qui périodiquement immerge le creuset en quartz dans la masse fondue et l'en ressort.

Hubmotor

Gebläse+Filter

Nickeltiegel

Thermoelement

Ofen

Boroxidschicht

Thermoelement

Thermoelement

KOH-Schmelze
(NaOH)-Schmelze

Quarztiegel plus GaAs-Kristall plus Boroxid

*Fig. 1*

EP 0 760 024 B1

Boroxid

Quarztiegel

GaAs - Kristall

Fig. 2

EP 0 760 024 B1